# EUROPEAN PATENT SPECIFICATION

(11) **EP 4 453 592 B1**
(45) Date of publication and mention of the grant of the patent: **03.12.2025**
(21) Application number: 22838809.6
(22) Date of filing: 19.12.2022
(51) Int. Cl.: G01R 33/26, G01R 33/32, G01R 33/60, G01N 24/10

(54) **SENSOR DEVICE FORMED OF DIAMOND MATERIAL**
SENSORVORRICHTUNG AUS DIAMANTMATERIAL
DISPOSITIF DE CAPTEUR FORMÉ D'UN MATÉRIAU DE DIAMANT

(30) Priority: 21.12.2021 GB 202118621
(43) Date of publication of application: 30.10.2024
(73) Proprietor: Element Six Technologies Limited, Didcot, Oxfordshire OX11 0QR (GB)
(72) Inventor: COLARD, Pierre-Olivier François Marc, Didcot, Oxfordshire OX11 0QR (GB); EDMONDS, Andrew Mark, Didcot, Oxfordshire OX11 0QR (GB); MARKHAM, Matthew Lee, Didcot, Oxfordshire OX11 0QR (GB)
(74) Representative: Mitchell, Matthew Benedict David
(86) International application number: PCT/EP2022/086750
(87) International publication number: WO 2023/117973

(56) References cited:
- EP-A1- 3 851 863
- MUROOKA T ET AL: "Photoelectrical detection of nitrogen-vacancy centers by utilizing diamond lateral p-i-n diodes", APPLIED PHYSICS LETTERS, AMERICAN INSTITUTE OF PHYSICS, 2 HUNTINGTON QUADRANGLE, MELVILLE, NY 11747, vol. 118, no. 25, 25 June 2021 (2021-06-25), XP012257682, ISSN: 0003-6951, [retrieved on 20210625], DOI: 10.1063/5.0055852
- FORNERIS J ET AL: "Electrical control of deep NV centers in diamond by means of sub-superficial graphitic micro-electrodes", CARBON, ELSEVIER OXFORD, GB, vol. 113, 15 November 2016 (2016-11-15), pages 76 - 86, XP029850684, ISSN: 0008-6223, DOI: 10.1016/J.CARBON.2016.11.031
- E. BOURGEOIS ET AL: "Photoelectric detection of electron spin resonance of nitrogen-vacancy centres in diamond", NATURE COMMUNICATIONS, vol. 6, no. 1, 21 October 2015 (2015-10-21), XP055743125, DOI: 10.1038/ncomms9577

## Description

### Field

The invention relates to the field of sensor devices, in particular sensor devices formed from diamond material.

### Background

Point defects in synthetic diamond material, particularly quantum spin defects and/or optically active defects, have been proposed for use in various imaging, sensing, and processing applications including: luminescent tags; magnetometers; spin resonance devices such as nuclear magnetic resonance (NMR) and electron spin resonance (ESR) devices; spin resonance imaging devices for magnetic resonance imaging (MRI); quantum information processing devices such as for quantum communication and computing; magnetic communication devices; and gyroscopes for example.

It has been found that certain defects are particularly useful for sensing and quantum processing applications when in their negative charge state. For example, the negatively charged nitrogen-vacancy defect (NV⁻) in synthetic diamond material has attracted a lot of interest as a useful quantum spin defect because it has several desirable features including:
(i) Its electron spin states can be coherently manipulated with high fidelity and have an extremely long coherence time (which may be quantified and compared using the transverse relaxation time T₂ and/or T₂*);
(ii) Its electronic structure allows the defect to be optically pumped into its electronic ground state allowing such defects to be placed into a specific electronic spin state even at non-cryogenic temperatures. This can negate the requirement for expensive and bulky cryogenic cooling apparatus for certain applications where miniaturization is desired. Furthermore, the defect can function as a source of photons which all have the same spin state; and
(iii) Its electronic structure comprises emissive and non-emissive electron spin states, which allows the electron spin state of the defect to be read out through photons. This is convenient for reading out information from synthetic diamond material used in sensing applications such as magnetometry, spin resonance spectroscopy, and imaging. Furthermore, it is a key ingredient towards using NV⁻ defects as qubits for long-distance quantum communications and scalable quantum computation. Such results make the NV⁻ defect a competitive candidate for solid-state quantum information processing (QIP).

The NV⁻ defect in diamond consists of a substitutional nitrogen atom adjacent to a carbon vacancy. Its two unpaired electrons form a spin triplet in the electronic ground state (³A), the degenerate mₛ = ± 1 sublevels being separated from the mₛ = 0 level by 2.87 GHz. The electronic structure of the NV⁻ defect is such that the mₛ = 0 sublevel exhibits a high fluorescence rate when optically pumped. In contrast, when the defect is excited in the mₛ = ± 1 levels, it exhibits a higher probability to cross over to the non-radiative singlet state (¹A) followed by a subsequent relaxation into mₛ = 0. As a result, the spin state can be optically read out, the mₛ = 0 state being "bright" and the mₛ = ± 1 states being dark. When an external magnetic field or strain field is applied, the degeneracy of the spin sublevels mₛ = ± 1 is broken via Zeeman splitting. This causes the resonance lines to split depending on the applied magnetic/strain field magnitude and its direction. This dependency can be used for magnetometry by probing the resonant spin transitions using microwaves (MW) and using optically detected magnetic resonance (ODMR) spectroscopy to measure the magnitude and, optionally, the direction of the applied magnetic field.

NV⁻ defects in synthetic diamond material can be formed in a number of different ways including:
(i) formation during growth of the synthetic diamond material where a nitrogen atom and a vacancy are incorporated into the crystal lattice as a nitrogen-vacancy pair during growth;
(ii) formation after diamond material synthesis from native nitrogen and vacancy defects incorporated during the growth process by post-growth annealing the material at a temperature (around 800°C) which causes migration of the vacancy defects through the crystal lattice to pair up with native single substitutional nitrogen defects;
(iii) formation after diamond material synthesis from native nitrogen defects incorporated during the growth process by irradiating the synthetic diamond material to introduce vacancy defects and then subsequently annealing the material at a temperature which causes migration of the vacancy defects through the crystal lattice to pair up with native single substitutional nitrogen defects;
(iv) formation after diamond material synthesis by implanting nitrogen defects into the synthetic diamond material after diamond material synthesis and then annealing the material at a temperature which causes migration of the native vacancy defects through the crystal lattice to pair up with implanted single substitutional nitrogen defects; and
(v) formation after diamond material synthesis by irradiating the synthetic diamond material to introduce vacancy defects, implanting nitrogen defects into the synthetic diamond material before or after irradiation, and annealing the material at a temperature which causes migration of the vacancy defects through the crystal lattice to pair up with implanted single substitutional nitrogen defects.

Various different types of diamond material have been disclosed in the prior art for use in various different types of magnetometry applications including WO2010/010352 and WO2010/010344 which disclose low nitrogen content single crystal chemical vapour deposited (CVD) diamond materials for applications such as magnetometry, and WO2010/149775 which discloses irradiated and annealed single crystal CVD diamond materials for applications such as magnetometry.

A limitation of ODMR, described above, is that the intensity of photoluminescence saturates at high pump powers. Furthermore, the collection efficiency of ODMR can be limited by the high refractive index of diamond.

Photoelectric Detection of Magnetic Resonance (PDMR) has been proposed as an alternative to ODMR, which allows the direct photoelectric measurement of the spin state of a spin defect in a diamond lattice, based on the detection of charge carriers generated by excited spin centres. This technique is described in Bourgeois, E. et. al., "Photoelectric detection of electron spin resonance of nitrogen-vacancy centres in diamond". Nature Communications, 6, 2015 and US 10,274,551. An advantage of PDMR is that it does not cause saturation at high pump powers as it is not limited by the lifetime of NV excited states but only by the recombination rates. This means that higher detection rates are achievable.

A further practical advantage of PDMR over ODMR is that it allows easier interfacing with electronics. Furthermore, higher resolution is achievable thanks to quadratic power dependence of photocurrent.

However, a limitation of PDMR is that in order to collect charge carriers from an excited spin defect, the spin defect must be located sufficiently close to a surface electrode to allow the charge carrier to drift through the diamond lattice and reach the surface electrode. Defects in the diamond limit the mobility of carriers and electric field penetration depth, thereby affecting the photocurrent. PDMR therefore currently has limitations in its use for a number of quantum

EP 3 851 863 A1 discloses a sensor device formed of diamond material comprising spin defects and an electrically conducting region at the surface of the diamond material.

### Summary

It is an object of the invention to provide a diamond sensor device that proves a more efficient way of collecting charge carriers during PDMR. This is achieved by providing electrodes within the bulk of a diamond material and proximate to a spin defect, allowing both the exploitation of 'bulk' spin defects and also the possibility of obtaining three dimensional positional information from within the diamond material.

According to a first aspect, there is provided a sensor device formed of diamond material. The sensor device comprises a plurality of spin defects located in the diamond material, a plurality of electrically conducting regions extending from the interior location of the diamond material to the surface of the diamond material, each electrically conducting region being located so as to be interactable with a corresponding spin defect of the plurality of spin defects, wherein each electrically conducting region at the surface of the diamond material is arranged to connect to a detector, the detector configured to detect charge carriers excited from the plurality of spin defects via the corresponding electrically conducting region.

An advantage of this type of sensor device is that it allows the use of a higher volume of the diamond sensor than would be the case if one were limited to using spin defects close to the surface, and also allows the collection of greater overall signals. Electric field penetration depth and charge carriers drift length strongly limit the number of usable sensing centres to those close to the surface using standard techniques. The invention allows the collection of signals from spin defects within the bulk of the diamond and provides an increase in overall signal, and ultimately sensitivity. Alternatively, signals from individual spin centres or groups of spin centres can be queried.

As an option, the diamond material comprises any of Chemical Vapour Deposition, CVD, diamond material, high pressure high temperature, HPHT, diamond, and natural diamond.

The electrically conducting region optionally comprises boron doped diamond. As a further option, the diamond material comprises at least one layer of boron doped diamond adjacent to a layer of diamond containing one of said spin defects.

As an alternative option, the electrically conducting region comprises electrically conducting non-diamond carbon. As a further option, the electrically conducting non-diamond carbon comprises graphite.

As an option, each spin defect is selected from any of a negatively charged nitrogen vacancy centre, a silicon-vacancy centre, a tin-vacancy centre, a germanium-vacancy centre, a nickel related defect and a chromium-related defect.

According to a second aspect, there is provided a method of forming a sensor device formed of diamond material, the method comprising:
providing a plurality of spin defects located in the diamond material; providing a plurality of electrically conducting regions extending from an interior location of the diamond material to a surface of the diamond material, each electrically conducting region being located so as to be interactable with a corresponding spin defect of the plurality of spin defects; connecting each electrically conducting region at the surface of the diamond material to a current detector, the current detector configured to detect charge carriers excited from the plurality of spin defects via the corresponding electrically conducting regions.

As an option, the spin defect is selected from any of a negatively charged nitrogen vacancy centre, a silicon-vacancy centre, and defects related to nickel, tin, germanium or chromium.

The method optionally comprises growing a first layer of diamond material, the first layer comprising any of a spin defect and a precursor defect that is processable to become a spin defect, and growing a second layer of electrically conducting boron doped diamond adjacent to the first layer. As a further option, the processing comprises irradiating and annealing the diamond material to form the spin defect.

As an alternative option, the method comprises forming the electrically conducting region by forming electrically conducting non-diamond carbon in the diamond material. As a further option, the method comprises determining the location of a spin defect and subsequently providing the electrically conducting region by using a short-pulse laser to form a conducting non-diamond carbon path in the diamond material such that a portion of the conducting non-diamond carbon path is located so as to be interactable with the spin defect. This allows conductive tracks to be located close to individual spin defects. As a further option, the electrically conducting non-diamond carbon is formed by using a short-pulse laser.

### Brief Description of Drawings

Non-limiting embodiments will now be described by way of example and with reference to the accompanying drawings in which:
Figure 1 illustrates schematically a side elevation cross section view of a diamond device in which electrically conductive regions are provided by electrically conducting non-diamond carbon tracks;
Figure 2 illustrates schematically a side elevation cross section view of a diamond device in which electrically conductive regions are provided by electrically conducting non-diamond carbon tracks in an alternative configuration;
Figure 3 illustrates schematically a side elevation cross section view of a diamond device in which electrically conductive regions are provided by layers of electrically conducting diamond;
Figure 4 is a flow diagram showing exemplary steps for forming a diamond sensor device;
Figure 5 is a flow diagram showing exemplary steps for forming a diamond sensor device in which electrically conductive regions are provided by electrically conducting non-diamond carbon tracks; and
Figure 6 is a flow diagram showing exemplary steps for forming a diamond sensor device in which electrically conductive regions are provided by layers of electrically conducting diamond.

### Detailed description

The following description refers to sensors formed from diamond containing at least one spin centre. For convenience, the description refers to the exemplary spin centre being a negatively charged nitrogen-vacancy centre (NV⁻). However, it is known that various spin centres can be formed in diamond. These include silicon-vacancy centres, tin-vacancy centres, germanium-vacancy centres, nickel related defects and chromium-related defects. The skilled person will appreciate that the structure and methods described herein apply to any type of spin centre that can be used in a diamond sensor.

The inventors have realised that PDMR can be optimised if charge collection does not just occur at an electrode disposed at the surface of the diamond, but if an electrically conducting region is provided within the body of the diamond. In this way, charge collection can be optimised to increase the collected signal and sensitivity, and more of the diamond can be utilized. Furthermore, individual spin centres in the diamond can be interrogated.

In order to function, the spin centres and the electrically conducting regions must be located within an interactable distance of one another. In practice, this typically means that they are within the drift length of a charge carrier in order for a charge carrier from the spin centre to reach the electrically conducting region and be detected.

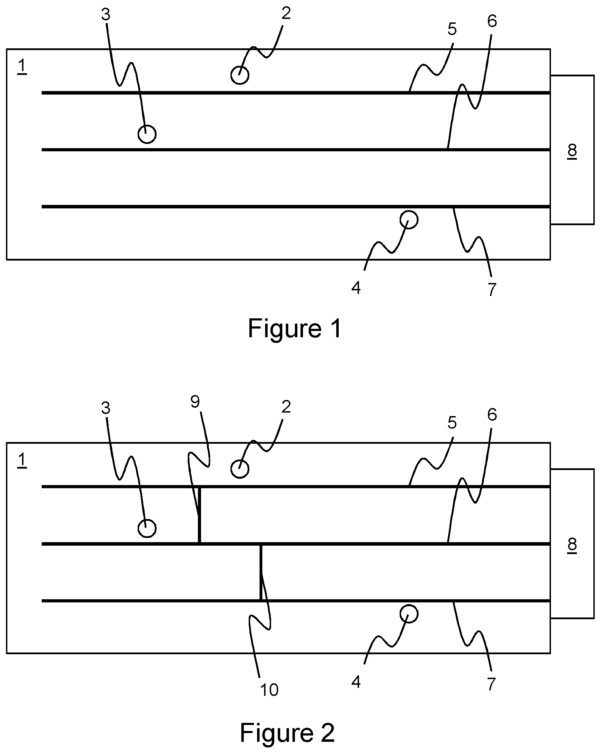

Referring to Figure 1 herein, there is illustrated schematically a side elevation cross section view of a first exemplary diamond device 1. In this example, NV centres 2, 3, 4 are disposed within the body of the diamond 1. Electrically conducting non-diamond carbon is provided within the body of the diamond 1 in the form of tracks 5, 6, 7. The tracks 5, 6, 7 are electrically connected to an output device 8.

The electrically conducting regions may be provided, for example, by using a short pulse laser to convert diamond in the body to an electrically conducting carbon phase such as graphite . Such a technique is described in Bloomer et. al., "A single crystal CVD diamond x-ray beam diagnostic with embedded graphitic wire electrodes", 2054, 60058 https://doi.org/10.1063/1.5084689. Short-laser pulses can be used to selectively transform diamond to conductive graphite with micrometre accuracy. This can then be used to create conductive wires running in the x and y plane and at different depths, that can selectively excite and read separate regions containing NV centres of the diamond in all three dimensions. This technique can be used on any kind of diamond with the right spin centres, for example CVD diamond, natural diamond, or high pressure high temperature (HPHT) diamond.

Electrically conducting regions may be provided throughout the body of the diamond 1 so that on average, some will be in an interactable distance from an NV centre. Alternatively, the locations of the spin centres within the diamond may be determined and electrically conducting regions 5, 6, 7 can subsequently be formed within the diamond so as to be within an interactable distance of the NV centres 2, 3, 4.

The electrically conducting regions 5, 6, 7 may be connected such that all of the NV centres 2, 3, 4 within an interactable distance of any of the electrically conducting regions 5, 6, 7 can be queried at the same time. This increases the overall signal obtained and improves the sensitivity of the device. The electrically conducting regions may be connected in this way at the output device 8. Alternatively, and as shown in Figure 2, the electrically conducting regions 5, 6, 7 may be connected to one another by further electrically conducting regions 9, 10 within the diamond 1 to ensure that the overall signal is optimized.

Alternatively, the electrically conducting regions 5, 6, 7 shown in Figure 1 may be connected such that individual NV centres 2, 3, 4 or groups of NV centres can be queried by detecting charge carriers at individual electrically conducting regions 5, 6, 7. Typical applications include detecting gradients in B (or in RF field) or have one more dimension to apply a gradient in B (to do 3D RF sensing for example).

It will be appreciated that creating electrically conducting regions in an existing diamond, as shown in Figures 1 and 2, is not the only way to create electrically conducting regions. Where the diamond used is CVD diamond, electrically conducting regions can be created in the body of the diamond during the growth process.

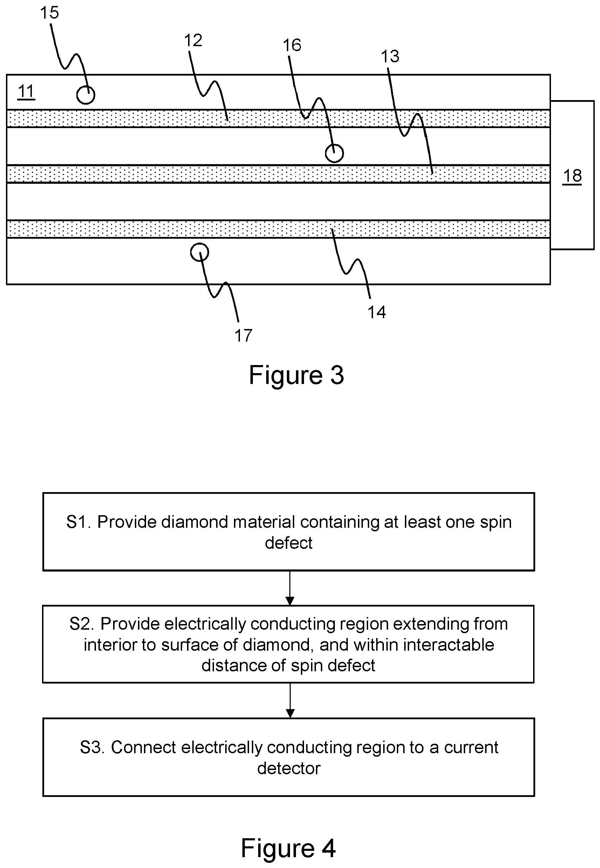

Referring to Figure 3 herein, there is illustrated schematically a side elevation cross section view of a diamond device in which electrically conductive regions are provided by layers of electrically conducting diamond. The diamond device 11 comprises layers 12, 13, 14 of electrically conducting diamond disposed between layers of dielectric diamond that contain the NV centres 15, 16, 17. This can be achieved during growth of CVD diamond by intermittently adding a boron-containing additive to the gases in order to form electrically conducting layers of boron doped diamond (BDD), as described more fully in, for example, WO 2014/044607.

The layers 12, 13, 14 of BDD are electrically connected to an output device 18. As with the embodiments shown in Figure 1, each layer 12, 13, 14 can be used individually to query NV centres located within an interactable distance from the layer, or can be used together to increase the strength of the signal and the device sensitivity.

While the embodiment shown in Figure 3 has two-dimensional layers of BDD running through the diamond, the skilled person will realise that by careful masking and overgrowth, three dimensional structures of BDD can be created throughout the body of the diamond 11. However, as a practical matter, three dimensional electrically conducting regions can be more cheaply and easily created by using a short pulse laser to create those regions within the diamond than growing them.

Referring to Figure 4 is a flow diagram showing exemplary steps for forming a diamond sensor device, described in general terms. The following numbering corresponds to that of Figure 4:
S1. A diamond material is provided, that includes at least one spin defect located in the diamond material. Examples of spin defects include negatively charged nitrogen vacancy centres, silicon-vacancy centres, and defects related to nickel, tin, germanium or chromium.
S2. An electrically conducting region is provided in the diamond material. The electrically conducting region is located so as to be interactable with the spin defect, and extends from an interior location of the diamond material to a surface of the diamond material. This is required so that an electrical contact can be made with an output device.
S3. The electrically conducting region is connected at the surface of the diamond to a current detector. The current detector is configured to detect charge carriers excited from the at least one spin defect via the electrically conducting region.

As described above, several electrically conducting regions are provided, and these may be used together to query the entire bulk of the diamond material in order to obtain a stronger signal, or may be used to selectively query different regions of the diamond material.

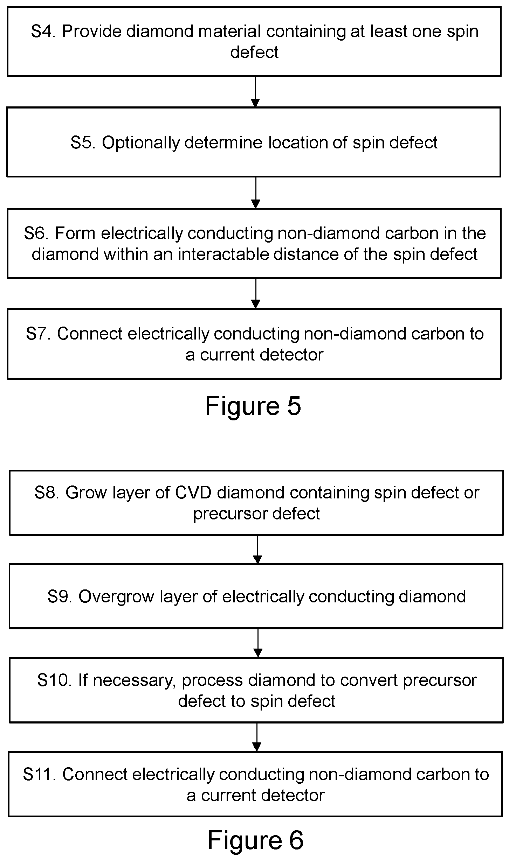

Turning now to Figure 5, there is shown a flow diagram showing exemplary steps for forming a diamond sensor device in which the electrically conductive regions are provided by electrically conducting non-diamond carbon tracks as illustrated in Figures 1 and 2. The following numbering corresponds to that of Figure 5.

S4. A diamond material is provided that contains a spin defect. The diamond may be CVD diamond, Natural diamond or HPHT diamond.

S5. In an optional embodiment, the location of the spin defect is determined prior to forming electrically conducting regions in the diamond.

S6. An electrically conducting region is provided within an interactable distance of the spin defect, for example by using a short-pulse laser to form electrically conducting non diamond carbon in the diamond material.

S7. The electrically conducting non diamond carbon is connected at a surface of the diamond to a current detector.

Referring now to Figure 6, there is shown a flow diagram showing exemplary steps for forming a diamond sensor device in which electrically conductive regions are provided by layers of electrically conducting diamond, such as BDD. The following numbering corresponds to that of Figure 6.

S8. A first layer of CVD diamond is grown that contains a spin defect, or a defect that is processable to form a spin defect.

S9. A second layer of electrically conducting CVD diamond is overgrown on the first layer. Steps S8 and S9 can be repeated depending on how many layers of electrically conducting diamond are required. Furthermore, masking and overgrowth during the growth process can be used to build three dimensional electrically conducting regions within the diamond if required.

S10. If necessary, and precursor defects are grown in the diamond, then these are processed to become spin defects. For example, if a precursor defect is single substitutional nitrogen, then irradiation and annealing can cause the single substitutional nitrogen to form a pair with a vacancy and create an NV centre.

S11. The electrically conducting diamond layers are connected at a surface of the diamond to a current detector.

The invention as defined in the appended claims has been shown and described with reference to the embodiments above. However, it will be understood by those skilled in the art that various changes in form and detail may be made without departing from the scope of the invention as defined by the appended claims. While the above description focuses of a PDMR sensor, there are other useful applications. For example, such a sensor may be used to measure gradients of B through the Z direction or could be used to address three dimensions in radio frequency sensing where a gradient of B is typically used in the in x and y directions, and the position of the magnetic resonance is determined to identify the RF frequency. This could also help address individual centres within the bulk of the material which can typically be useful to Quantum Information Processing or quantum communications.

## Claims

1. A sensor device formed of diamond material, the sensor device comprising:
a plurality of spin defects (2, 3, 4) located in the diamond material;
a plurality of electrically conducting regions (5, 6, 7) extending from the interior location of the diamond material to the surface of the diamond material, each electrically conducting region being located so as to be interactable with a corresponding spin defect of the plurality of spin defects;
wherein each electrically conducting region at the surface of the diamond material is arranged to connect to a detector, the detector configured to detect charge carriers excited from the plurality of spin defects via the corresponding electrically conducting region.

2. The sensor device according to claim 1, wherein the diamond material comprises any of Chemical Vapour Deposition, CVD, diamond material, high pressure high temperature, HPHT, diamond, and natural diamond.

3. The sensor device according to claim 1 or 2, wherein the electrically conducting region comprises boron doped diamond.

4. The sensor device according to claim 3, wherein the diamond material comprises at least one layer of boron doped diamond adjacent to a layer of diamond containing one of said spin defects.

5. The sensor device according to claim 1 or 2, wherein the electrically conducting regions comprise electrically conducting non-diamond carbon.

6. The sensor device according to claim 5, wherein the electrically conducting non-diamond carbon comprises graphite.

7. The sensor device according to any one of claims 1 to 5, wherein each spin defect is selected from any of a negatively charged nitrogen vacancy centre, a silicon-vacancy centre, a tin-vacancy centre, a germanium-vacancy centre, a nickel related defect and a chromium-related defect.

8. A method of forming a sensor device formed of diamond material, the method comprising:
providing a plurality of spin defects (2, 3, 4) located in the diamond material
providing a plurality of electrically conducting regions (5, 6, 7) extending from an interior location of the diamond material to a surface of the diamond material, each electrically conducting region being located so as to be interactable with a corresponding spin defect of the plurality of spin defects;
connecting each electrically conducting region at the surface of the diamond material to a current detector, the current detector configured to detect charge carriers excited from the plurality ospin defects via the corresponding electrically conducting regions.

9. The method according to claim 8, wherein each spin defect is selected from any of a negatively charged nitrogen vacancy centre, a silicon-vacancy centre, and defects related to nickel, tin, germanium or chromium.

10. The method according to claim 8 or 9, further comprising:
growing a first layer of diamond material, the first layer comprising any of a spin defect and a precursor defect that is processable to become a spin defect.
growing a second layer of electrically conducting boron doped diamond adjacent to the first layer.

11. The method according to claim 10, wherein the processing comprises irradiating and annealing the diamond material to form the spin defect.

12. The method according to claim 8 or 9, comprising providing the electrically conducting regions by forming electrically conducting non-diamond carbon in the diamond material.

13. The method according to claim 12, further comprising determining the location of a spin defect and subsequently providing the electrically conducting regions by using a short-pulse laser to form a conducting non-diamond carbon path in the diamond material such that a portion of the conducting non-diamond carbon path is located so as to be interactable with the spin defect.

14. The method according to claim 12 or 13, wherein the electrically conducting non-diamond carbon is formed by using a short-pulse laser.

## Patentansprüche

1. Sensorvorrichtung aus Diamantmaterial, umfassend:
eine Vielzahl von Spin-Defekten (2, 3, 4) im Diamantmaterial:
eine Vielzahl von elektrisch leitenden Bereichen (5, 6, 7), die sich vom Inneren des Diamantmaterials bis zur Oberfläche des Diamantmaterials erstrecken, wobei jeder elektrisch leitende Bereich so angeordnet ist, dass er mit einem korrespondierenden Spin-Defekt der Vielzahl von Spin-Defekten in Wechselwirkung treten kann;
wobei jeder elektrisch leitende Bereich an der Oberfläche des Diamantmaterials so angeordnet ist, dass er mit einem Detektor verbunden ist, wobei der Detektor so konfiguriert ist, dass er Ladungsträger erfasst, die von der Vielzahl von Spin-Defekten über den korrespondierenden elektrisch leitenden Bereich angeregt werden.

2. Sensorvorrichtung nach Anspruch 1, wobei das Diamantmaterial eines von chemisch abgeschiedenem Diamantmaterial (CVD), unter hohem Druck und hoher Temperatur hergestelltem Diamantmaterial (HPHT) und natürlichem Diamant umfasst.

3. Sensorvorrichtung nach Anspruch 1 oder 2, wobei der elektrisch leitende Bereich bordotierten Diamant umfasst.

4. Sensorvorrichtung nach Anspruch 3, wobei das Diamantmaterial mindestens eine Schicht aus bor-dotiertem Diamant umfasst, die an eine Schicht aus Diamant angrenzt, die einen der genannten Spin-Defekte enthält.

5. Sensorvorrichtung nach Anspruch 1 oder 2, wobei die elektrisch leitenden Bereiche elektrisch leitenden Nicht-Diamant-Kohlenstoff umfassen.

6. Sensorvorrichtung nach Anspruch 5, wobei der elektrisch leitende Nicht-Diamant-Kohlenstoff Graphit umfasst.

7. Sensorvorrichtung nach einem der Ansprüche 1 bis 5, wobei jeder Spin-Defekt aus negativ geladenen Stickstoff-Leerstellenzentrum, Silizium-Leerstellenzentrum, Zinn-Leerstellenzentrum, Germanium-Leerstellenzentrum, Nickel-bedingten Defekt und Chrombedingten Defekt ausgewählt ist.

8. Verfahren zur Herstellung einer aus Diamantmaterial gebildeten Sensorvorrichtung, umfassend:
Bereitstellen einer Vielzahl von Spin-Defekten (2, 3, 4), die sich in dem Diamantmaterial befinden;
Bereitstellen einer Vielzahl von elektrisch leitenden Bereichen (5, 6, 7), die sich vom Inneren des Diamantmaterials zu einer Oberfläche des Diamantmaterials erstrecken, wobei jeder elektrisch leitende Bereich so angeordnet ist, dass er mit einem korrespondierenden Spin-Defekt der Vielzahl von Spin-Defekten in Wechselwirkung treten kann;
Verbinden jedes elektrisch leitenden Bereichs an der Oberfläche des Diamantmaterials mit einem Stromdetektor, wobei der Stromdetektor so konfiguriert ist, dass er Ladungsträger erfasst, die von der Vielzahl von Spin-Defekten über die entsprechenden elektrisch leitenden Bereiche angeregt werden.

9. Verfahren nach Anspruch 8, wobei jeder Spin-Defekt aus negativ geladenen Stickstoff-Leerstellenzentrum, Silizium-Leerstellenzentrum und Defekten im Zusammenhang mit Nickel, Zinn, Germanium oder Chrom ausgewählt ist.

10. Verfahren nach Anspruch 8 oder 9, das weiterhin umfasst:
Züchten einer ersten Schicht aus Diamantmaterial, wobei die erste Schicht einen Spin-Defekt oder einen Vorläufer-Defekt umfasst, der zu einem Spin-Defekt verarbeitet werden kann;
Züchten einer zweiten Schicht aus elektrisch leitendem, mit Bor dotiertem Diamant angrenzend an die erste Schicht.

11. Verfahren nach Anspruch 10, wobei die Bearbeitung das Bestrahlen und Tempern des Diamantmaterials umfasst, um den Spin-Defekt zu erzeugen.

12. Verfahren nach Anspruch 8 oder 9, das das Bereitstellen der elektrisch leitenden Bereiche durch Ausbilden von elektrisch leitendem Nicht-Diamant-Kohlenstoff in dem Diamantmaterial umfasst.

13. Verfahren nach Anspruch 12, das weiterhin das Bestimmen der Position eines Spin-Defekts und das anschließende Bereitstellen der elektrisch leitenden Bereiche unter Verwendung eines Kurzpulslasers umfasst, um einen leitenden Nicht-Diamant-Kohlenstoffpfad in dem Diamantmaterial zu bilden, sodass ein Teil des leitenden Nicht-Diamant-Kohlenstoffpfads so positioniert ist, dass er mit dem Spin-Defekt in Wechselwirkung treten kann.

14. Verfahren nach Anspruch 12 oder 13, wobei der elektrisch leitende Nicht-Diamant-Kohlenstoff unter Verwendung eines Kurzpulslasers gebildet wird.

## Revendications

1. . Dispositif de capteur formé d'un matériau de diamant, le dispositif de capteur comprenant :
une pluralité de défauts de spin (2, 3, 4) situés dans le matériau de diamant ;
une pluralité de zones électriquement conductrices (5, 6, 7) qui s'étendent depuis l'emplacement intérieur du matériau de diamant vers la surface du matériau de diamant, chaque zone électriquement conductrice étant située de façon à pouvoir interagir avec un défaut de spin correspondant de la pluralité de défauts de spin ;
dans lequel chaque zone électriquement conductrice au niveau de la surface du matériau de diamant est prévue pour être reliée à un détecteur, le détecteur étant configuré pour détecter des porteurs de charge excités parmi la pluralité de défauts de spin via la zone électriquement conductrice correspondante.

2. . Dispositif de capteur selon la revendication 1, dans lequel le matériau de diamant comprend n'importe lequel d'un matériau de diamant à dépôt chimique en phase vapeur, CVD, d'un diamant à haute pression et à haute température, HPHT, et d'un diamant naturel.

3. . Dispositif de capteur selon la revendication 1 ou 2, dans lequel la zone électriquement conductrice comprend du diamant dopé au bore.

4. . Dispositif de capteur selon la revendication 3, dans lequel le matériau de diamant comprend au moins une couche de diamant dopé au bore adjacente à une couche de diamant contenant l'un desdits défauts de spin.

5. . Dispositif de capteur selon la revendication 1 ou 2, dans lequel les zones électriquement conductrices comprennent du carbone non diamant électriquement conducteur.

6. . Dispositif de capteur selon la revendication 5, dans lequel le carbone non diamant électriquement conducteur comprend du graphite.

7. . Dispositif de capteur selon l'une quelconque des revendications 1 à 5, dans lequel chaque défait de spin est choisi parmi n'importe lequel d'un centre de lacune d'azote chargé négativement, d'un centre de lacune de silicium, d'un centre de lacune d'étain, d'un centre de lacune de germanium, d'un défaut lié au nickel et d'un défaut lié au chrome.

8. . Procédé de formation d'un dispositif de capteur formé d'un matériau de diamant, le procédé comprenant :
le fait de prévoir une pluralité de défauts de spin (2, 3, 4) situés dans le matériau de diamant ;
le fait de prévoir une pluralité de zones électriquement conductrices (5, 6, 7) qui s'étendent depuis un emplacement intérieur du matériau de diamant vers une surface du matériau de diamant, chaque zone électriquement conductrice étant située de façon à pouvoir interagir avec un défaut de spin correspondant de la pluralité de défauts de spin ;
le raccordement de chaque zone électriquement conductrice au niveau de la surface du matériau de diamant à un détecteur de courant, le détecteur de courant étant configuré pour détecter des porteurs de charge excités parmi la pluralité de défauts de spin via les zones électriquement conductrices correspondantes.

9. . Procédé selon la revendication 8, dans lequel chaque défaut de spin est choisi parmi n'importe lequel d'un centre de lacune d'azote chargé négativement, d'un centre de lacune de silicium, et de défauts liés au nickel, à l'étain, au germanium ou au chrome.

10. . Procédé selon la revendication 8 ou 9, comprenant en outre :
le développement d'une première couche de matériau de diamant, la première couche comprenant n'importe lequel d'un défaut de spin et d'un défaut de précurseur qui peut être traité afin de devenir un défaut de spin ;
le développement d'une deuxième couche de diamant dopé au bore électriquement conducteur adjacente à la première couche.

11. . Procédé selon la revendication 10, dans lequel le traitement comprend l'irradiation et le recuit du matériau de diamant afin de former le défaut de spin.

12. . Procédé selon la revendication 8 ou 9, comprenant le fait de prévoir les zones électriquement conductrices en formant du carbone non diamant électriquement conducteur dans le matériau de diamant.

13. . Procédé selon la revendication 12, comprenant en outre la détermination de l'emplacement d'un défaut de spin puis le fait de prévoir les zones électriquement conductrices à l'aide d'un laser à impulsion courte afin de former un trajet de carbone non diamant conducteur dans le matériau de diamant de sorte qu'une partie du trajet de carbone non diamant conducteur soit située de façon à pouvoir interagir avec le défaut de spin.

14. . Procédé selon la revendication 12 ou 13, dans lequel le carbone non diamant électriquement conducteur est formé à l'aide d'un laser à impulsion courte.
